# EUROPÄISCHE PATENTSCHRIFT

(11) **EP 1 574 822 B1**
(45) Veröffentlichungstag und Bekanntmachung des Hinweises auf die Patenterteilung: **23.04.2008**
(21) Anmeldenummer: 03809903.2
(22) Anmeldetag: 30.10.2003
(51) Int. Cl.: G01D 5/12, G08C 17/00, G01R 15/14

(54) **VORRICHTUNG ZUR FERNÜBERWACHUNG DES ZUSTANDS VON ÜBERLANDLEITUNGEN**
DEVICE FOR TELEMONITORING THE STATE OF AERIAL POWER LINES
DISPOSITIF DE CONTROLE A DISTANCE DE L'ETAT DE LIGNES AERIENNES DE TRANSPORT D'ELECTRICITE

(30) Priorität: 31.10.2002 RU 2002129160
(43) Veröffentlichungstag der Anmeldung: 14.09.2005
(73) Patentinhaber: Mekhanoshin, Boris Losifovitch, Moscow, 127349 (RU); Shkaptsov, Vladimir Aleksandrovitch, Moscow, 125171 (RU)
(72) Erfinder: Mekhanoshin, Boris Losifovitch, Moscow, 127349 (RU); Shkaptsov, Vladimir Aleksandrovitch, Moscow, 125171 (RU)
(74) Vertreter: Jeck, Anton
(86) Internationale Anmeldenummer: PCT/RU2003/000460
(87) Internationale Veröffentlichungsnummer: WO 2004/040239

(56) Entgegenhaltungen:
- EP-A- 1 099 951
- WO-A1-99/48070
- RU-C1- 2 143 165
- US-A- 4 420 752
- US-A- 4 904 996
- US-A- 5 029 101
- US-A- 5 565 783
- PATENT ABSTRACTS OF JAPAN Bd. 2000, Nr. 01, 31. Januar 2000 (2000-01-31) & JP 11 281702 A (NGK INSULATORS LTD), 15. Oktober 1999 (1999-10-15)
- PATENT ABSTRACTS OF JAPAN Bd. 2002, Nr. 10, 10. Oktober 2002 (2002-10-10) & JP 2002 162431 A (FUJI ELECTRIC CO LTD), 7. Juni 2002 (2002-06-07)
- PATENT ABSTRACTS OF JAPAN Bd. 2000, Nr. 01, 31. Januar 2000 (2000-01-31) & JP 11 281700 A (NGK INSULATORS LTD), 15. Oktober 1999 (1999-10-15)

## Beschreibung

Die Erfindung bezieht sich auf die Fernüberwachung von Objekten im Bereich der Elektroenergetik und ist für die Gewinnung von Daten über den Zustand einer Leitung einer Hochspannungsfernleitung (HFL) bestimmt. Zu den zu überwachenden Parametern des HFL-Drahts zählen insbesondere dessen Temperatur, Strom, mechanische Reißbelastung und die statischen und dynamischen Parameter der Position des HFL-Drahts im Raum, der minimalen Höhe des HFL-Drahts über der Erde, die Parameter der Schwingungen des HFL-Drahts unter der Einwirkung von Wind oder die Selbstschwingungen des HFL-Drahts unter der Einwirkung von Wind bei nicht symmetrischer Eisablagerung auf dem HFL-Draht.

Die Ergebnisse der Fernüberwachung können für die Steuerung der Betriebsarten der Hochspannungsfernleitungen verwendet werden, um einen sicheren Betrieb der Hochspannungsfernleitungen bei maximaler Nutzung der Leitungsbelastungsfähigkeit zu gewährleisten.

Durch [1] (s. beigefügte Quellenangabe) ist eine Vorrichtung bekannt, die an einem Draht einer Hochspannungsfernleitung angebracht wird; diese Vorrichtung enthält: einen Temperaturmessfühler und eine Speichervorrichtung, mit der die Temperatur des Drahts der Hochspannungsfernleitung gemessen werden kann und die gemessenen Werte bis zu deren Ablesen unter stationären Bedingungen mittels eines PC gespeichert werden können. Die Nachteile der Vorrichtung nach [1] bestehen darin, dass die Vorrichtung von der Hochspannungsfernleitung zum Ablesen der Messergebnisse abgenommen werden muss und dass die Auswahl der Messparameter beschränkt ist.

Durch [2] ist eine tragbare Vorrichtung bekannt, die einen Laserentfemungsmesser darstellt, der die Höhe eines Drahts der Hochspannungsfernleitung über der Erdoberfläche an einer vorgegebenen Stelle messen kann. Die Nachteile dieser Vorrichtung bestehen darin, dass eine Messperson vorhanden sein muss, die die Änderungen und Messungen vornimmt, und dass die Auswahl der zu messenden Parameter beschränkt ist.

Durch [3] ist eine Vorrichtung bekannt, die ein stationäres System darstellt, das ein in der Nähe einer Hochspannungsfernleitung aufzustellendes Lasermessgerät enthält; dieses Lasermessgerät registriert statische und dynamische Parameter über den Zustand der Leitung, darunter auch diejenigen, die bei solchen Phänomenen wie die erwähnte Schwingung und Selbstschwingung entstehen. Diese Vorrichtung ist im Grunde eine Modifikation des Laserentfernungsmessers nach [2], der erlaubt, Prozesse des dynamischen Verhaltens der Leitung zu überwachen. Zu den Nachteilen dieser Vorrichtung gehören deren Sperrigkeit und die Notwendigkeit der ständigen Einstellung und Wartung.

Ein gemeinsamer Nachteil der Vorrichtungen nach [1, 2, 3] ist das Fehlen der Mittel für die Datenübertragung der Messergebnisse an die Stelle der Datenerfassung, daher ist es unmöglich, die Überwachung des Zustands der Hochspannungsfernleitung im Echtzeitbetrieb durchzuführen.

Ferner sind durch [4] und [5] Vorrichtungen zur Überwachung der Parameter eines Drahts einer Hochspannungsfernleitung bekannt, die über Mittel zur Datenübertragung für die Überwachung im Echtzeitbetrieb verfügen.

Die Vorrichtung [4] wird auf dem Mast der Hochspannungsfernleitung aufgestellt und stellt einen Reißbelastungssensor für die Leitung dar (misst die mechanische Belastung, die auf einen aufgehängten Isolator übergetragen wird), der mit Mitteln zur vorläufigen Bearbeitung, Speicherung und Rundfunkübermittlung der Messdaten ausgerüstet ist. Dadurch kann eine Überwachung der Reißbelastung der Hochspannungsfernleitungen in Echtzeit durchgeführt werden. Aufgrund des mit der Vorrichtung nach [4] ermittelten Werts der Reißbelastung können weitere Parameter des Zustands der Leitung berechnet werden. Der Nachteil der Vorrichtung nach [4] besteht darin, dass ein spezialisiertes, technologisches System einer Funkverbindung aufgebaut und betrieben werden muss. Weitere Nachteile sind die geringe Zuverlässigkeit und geringe Genauigkeit der ermittelten Daten. Letzteres hängt damit zusammen, dass der Zustand der Leitung nicht anhand des Ergebnisses der unmittelbaren Messungen solcher Parameter, wie Temperatur und Lage der Leitung, sondern durch die Analyse von indirekten Merkmalen festgestellt wird. So wird die Temperatur der Leitung auf indirekte Weise als Ergebnis von Berechnungen unter Verwendung von Daten über die Größe der Reißbelastung der Leitung, der Umgebungstemperatur, der Windgeschwindigkeit und der Strombelastung der Leitung zum Zeitpunkt der Messung ermittelt. Die Lage der Leitung und die Höhe der Leitung über der Erdoberfläche können auch nur auf indirekte Weise ermittelt werden, und zwar unter Verwendung von Daten über die Position der Leitung bei den Berechnungsverhältnissen, der Formeln und der Abhängigkeiten, die die Korrelation der Größe der zu überwachenden Reißbelastung der Leitung mit dem Durchhang charakterisieren.

Die als Prototyp geltende Vorrichtung zur Fernüberwachung des Zustands einer Hochspannungsfernleitung nach [5] enthält ein Gehäuse, das mit Mitteln zur Befestigung an der Fernleitung ausgerüstet ist, eine im Gehäuse untergebrachte Stromversorgungseinheit und ein Mess- und Übertragungsmodul. Diese Prototyp-Vorrichtung wird an einem Draht der Hochspannungsfernleitung befestigt und arbeitet als unabhängiges Element im System zur Überwachung des Zustands der Hochspannungsfernleitungen im Echtzeitbetrieb und gewährleistet die Datenübertragung über das spezialisierte System der technologischen Informationen (Es wird vorgeschlagen, ein solches System nach [5] auf der Basis einer Hochfrequenzverbindung über die Hochspannungsfernleitungen mit Hilfe von Hochspannungsanschlusseinheiten nach [6] zu schaffen). Der Nachteil des Prototyps besteht darin, dass zur Sicherstellung seines Betriebs im Überwachungssystem zusätzlich spezialisierte, technologische Mittel eingesetzt und betrieben werden müssen. Dieser Nachteil ist durch Folgendes bedingt. Die Vorrichtung, die am Draht der Hochspannungsfernleitung als unabhängiges Messelement im Überwachungssystem angebracht ist, braucht zur Messung der Parameter der Leitungsposition und/oder zur Verbindung mit der Erfassungsstelle der Messinformationen äußere Mittel. Für den Prototyp muss als solche Mittel im Überwachungssystem eine zusätzliche, spezielle Ausrüstung (zum Beispiel Laserentfemungsmesser nach [2], [3] und/oder jeweils ein Hochfrequenzverbindungssystem) vorgesehen werden, deren Ausfall oder Betriebsunterbrechung sowohl die Zuverlässigkeit des Überwachungssystems insgesamt als auch die ihres unabhängigen Messelements verringert.

Durch die US 5 565 783 A ist eine Vorrichtung gemäß dem Oberbegriff des Anspruchs 1 bekannt. Diese Vorrichtung soll abnormale Strom- und Spannungswerte mit einem Stromsensor und einem Spannungssensor erkennen. Der Stromsensor soll erhebliche Abweichungen des Leitungsstroms vom Nennwert erkennen soll, um Fehlerfälle und den Fehlerort zu erkennen. Die Vorrichtung arbeitet mit einer Steckantenne, die mit einem Sender und einer Glasfaserleitung verbunden ist, die den Sender mit einem Prozessor verbindet.

Durch die Patent Abstracts of Japan, Bd. 2000, Nr. 01,31 und die JP 11 281702 A ist ferner eine Vorrichtung zur Überwachung einer Hochspannungsfernleitung bekannt, bei der ein Kurzschluss auf der Basis von festgestellten Werten eines Stromtransformators erkannt werden soll. Ein mobiles Telefon überträgt die Information, ob ein Unfallzustand vorliegt oder nicht.

Schließlich ist durch die Patent Abstracts of Japan, Bd. 2000, Nr. 10, und die JP 2002 162431 A eine Vorrichtung zur Erleichterung der Überwachung der Wartung und Inspektion mittels der Darstellung einer Stelle auf einer Karte bekannt, an der ein Fehler aufgetreten ist. Es werden Daten über die Elektrizitätsmenge auf einer Übertragungsleitung gesammelt, die dann an einer Datenendstelle empfangen werden; eine Fehlerstelle wird nahe einer Datenerfassungsstelle festgestellt. Jede Endstelle ist mit einem GPS-Empfangsteil ausgerüstet und überträgt eine Positionsinformation zu einer Zentraleinheit. Die Zentraleinheit zeigt den Ort der auf einer Karte vorhandenen Endstelle innerhalb eines Fehlerstellenfeststellbereichs an.

Die letzten drei genannten, bekannten Vorrichtungen betreffen Vorrichtungen, die Strom- oder Spannungsparameter der über die Fernleitung übertragenen elektrischen Leistung und die Abweichung dieser Parameter von Normalwerten feststellen, um Leitungsfehler, die bereits zu Unfallstörungen geführt haben, festzustellen und Hilfsmaßnahmen einzuleiten. Dagegen befasst sich die vorliegende Erfindung hauptsächlich mit Parametern nichtelektrischer Art, wie die Feststellung der Leitungstemperatur, dem Leitungsdurchhang oder dem Leitungsschwingen. Daraus kann dann eine Entscheidung abgeleitet werden, wie die Fernleitung belastet werden kann, um von vornherein Unfallstörungen zu vermeiden. Wenn beispielsweise eine Erhöhung der Leitungsbelastung vorgenommen wird, so folgt daraus eine Erhöhung der Leitungstemperatur, eine Durchhangerhöhung und eine Abstandsverminderung. Die letzten drei genannten, bekannten Vorrichtungen offenbaren solche nichtelektrischen Parameter nicht.

Die Aufgabe der Erfindung besteht darin, die Notwendigkeit der Schaffung und des Betriebs von spezialisierten, technologischen Mitteln zur Messung der Parameter der Leitungslage und\oder zur Verbindung mit der Erfassungsstelle der Messinformation auszuschließen und dadurch die Zuverlässigkeit des Betriebs der Vorrichtung als unabhängiges Element im System zur Überwachung des Zustands der Hochspannungsfernleitung zu erhöhen.

Die Aufgabe wird durch die Merkmale des Anspruches 1 gelöst.

Der Gegenstand der Erfindung gemäß einer weiteren Variante ist eine Vorrichtung zur Fernüberwachung des Zustands eines Drahts einer Fernleitung, die ein Gehäuse, Mittel zur Befestigung des Gehäuses an einem Draht der Fernleitung und eine im Gehäuse untergebrachte Versorgungseinheit sowie eine Mess- und Übertragungseinheit umfasst, mit der Signale aus dem globalen Positionierungssystem (GPS) gewonnen, danach die Position der Einheit ermittelt, diese Angaben in digitale Daten umgewandelt und über das öffentliche Zellenfunknetz übermittelt werden können bzw. kann.

Der Gegenstand der Erfindung gemäß der weiteren Variante ist auch eine Vorrichtung zur Fernüberwachung des Zustands einer Fernleitung, die ein Gehäuse, Mittel zur Befestigung des Gehäuses an einem Draht der Fernleitung und eine im Gehäuse untergebrachte Versorgungseinheit sowie Mess- und Übertragungseinheit umfasst, mit der Signale aus dem globalen Positionierungssystem empfangen, danach die Position der Einheit im dreidimensionalen Koordinatensystem festgestellt und die empfangenen Daten über die Koordinate an die Erfassungsstelle der Messinformationen übermittelt werden können bzw. kann.

Die Gesamtheit der Merkmale jeder der genannten Varianten der Erfindung erlaubt, die Zuverlässigkeit der Vorrichtung als unabhängiges Element im System zur Überwachung des Zustands der Hochspannungsfernleitungen zu erhöhen.

Die erste Variante der Erfindung ist dadurch gekennzeichnet, dass ein die Temperatur der Fernleitung feststellender Sensor die Messsignale liefert.

Gemäß einer weiteren Ausbildung der ersten Variante zur Verwirklichung der Erfindung ist das Mess- und Übertragungsmodul mit der Möglichkeit des Empfangs von Signalen aus dem globalen Positionierungssystem sowie mit der Möglichkeit der Ermittlung der Angaben nach diesen Signalen über die Drahtposition im dreidimensionalen Koordinatensystem ausgebildet. Dadurch kann eine Überwachung der statischen und dynamischen Parameter der Drahtposition durchgeführt werden, wobei die Zuverlässigkeit des unabhängigen Betriebs der Vorrichtung gewährleistet ist.

Die zweite Variante der Erfindung ist dadurch gekennzeichnet, dass das Mess- und Übertragungsmodul eine Steuereinheit, eine Einheit zum Empfangen und Umwandeln der Signale über den Zustand der Leitung, die mit einem an ihrem Eingang angeschlossenen Signalempfänger des globalen Positionierungssystem ausgerüstet ist, eine Einheit zur vorläufigen Bearbeitung der gewonnenen Informationen und der nachfolgenden Datenspeicherung und eine Einheit zur Kommunikation und Datenübertragung umfasst, wobei die Einheit zur vorläufigen Bearbeitung der ermittelten Informationen und der nachfolgenden Datenspeicherung am Ausgang der Einheit zum Empfangen und Umwandeln der Signale über den Zustand der Leitung sowie am Eingang der Einheit zur Kommunikation und Datenübertragung angeschlossen ist

Die zweite Variante der Erfindung kann auch dadurch gekennzeichnet sein, dass das Mess- und Übertragungsmodul mit der Möglichkeit der Datenübertragung über das öffentliche Zellenfunknetz ausgebildet ist. Dadurch kann zusätzlich die Zuverlässigkeit des unabhängigen Funktionierens der Vorrichtung nach der zweiten Variante der Erfindung erhöht werden.

Die beiden Varianten der Erfindung haben weitere Ausbildungen der Erfindung, die darin bestehen, dass:
- die Einheit zum Empfangen und Umwandeln der Signale über den Zustand der Leitung einen Sensor für die Stromparameter im Draht aufweist,
- die Einheit zum Empfangen und Umwandeln der Signale über den Zustand der Leitung einen Messfühler für die Drahttemperatur aufweist, der in das Mittel zur Befestigung des Gehäuses am Draht der Fernleitung eingebaut wird,
- die Einheit zur Kommunikation und Datenübertragung mit Mitteln zum Empfangen der Signale und zum Abfragen der Informationen und der digitalen Sollwerte sowie mit Mitteln zum Schutz vor unbefugtem Zugriff ausgerüstet ist.

Dadurch können in einzelnen Fällen der Realisierung der Vorrichtung die erforderlichen Sätze der zu überwachenden Parameter über den Zustand der Leitung und die funktionellen Möglichkeiten der Vorrichtung gewährleistet werden.

Die beiden Varianten der Erfindung weisen auch weitere Ausbildungen auf, die darin bestehen, dass die Stromversorgungseinheit als Akkumulator ausgebildet ist, der mit Mitteln zum Nachladen durch den Leitungsstrom und/oder durch eine zusätzlich vorgesehene Sonnenbatterie ausgerüstet werden kann. Dadurch kann die Zuverlässigkeit des unabhängigen Betriebs der Vorrichtung zusätzlich erhöht werden.

Die Erfindung wird nun anhand eines Ausführungsbeispiels näher erläutert.

Es zeigen:
- Fig. 1: ein Obersichtswirkschema einer Vorrichtung gemäß der Erfindung und
- Fig. 2: eine perspektivische Ansicht der Vorrichtung der Fig. 1, wobei diese Vorrichtung an einem Draht einer Hochspannungsfernleitung angebracht ist.

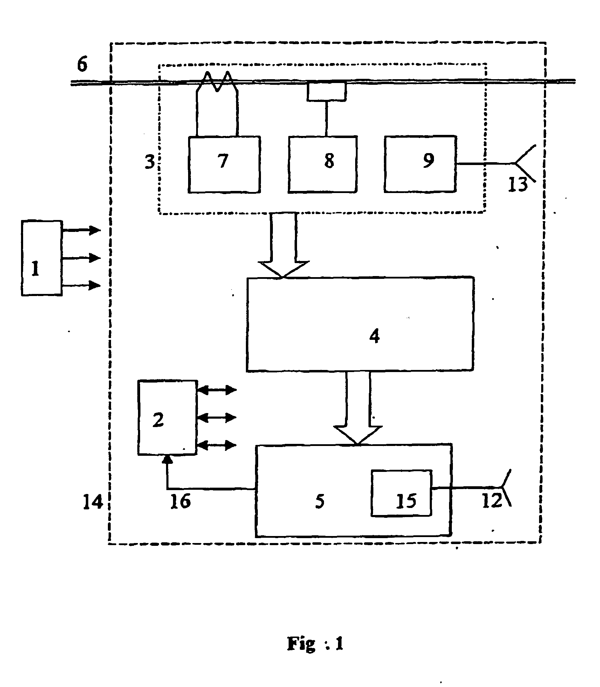

In Fig. 1 sind folgende Bauglieder dargestellt: eine Stromversorgungseinheit 1, eine Steuereinheit 2, eine Einheit 3 zum Empfangen und Umwandeln der Signale über den Zustand der Leitung der Hochspannungsfernleitung, eine Einheit 4 zur vorläufigen Datenbearbeitung und zur nachfolgenden Datenspeicherung, eine Einheit 5 zur Kommunikation und Datenübertragung und ein Draht 6 der Hochspannungsfernleitung.

Die Einheit 1 kann als Akkumulator ausgeführt sein und mit Mitteln zum Nachladen durch den Leitungsstrom und/oder von einer Sonnenbatterie ausgerüstet werden, die in diesem Fall zu der Vorrichtung gehört (in Fig. 1 nicht gezeigt).

Die Einheit 2 steuert die Einheiten 3, 4 und 5 und die ganze Vorrichtung insgesamt. Zur Einheit 3 gehören ein Sensor 7 für die Stromparameter im Draht 6, ein Messfühler 8 für die Drahttemperatur, ein Signalempfänger 9 für das globale Positionierungssystem GPS mit der Ermittlung seiner Position im dreidimensionalen Koordinatensystem (GPS-Empfänger).

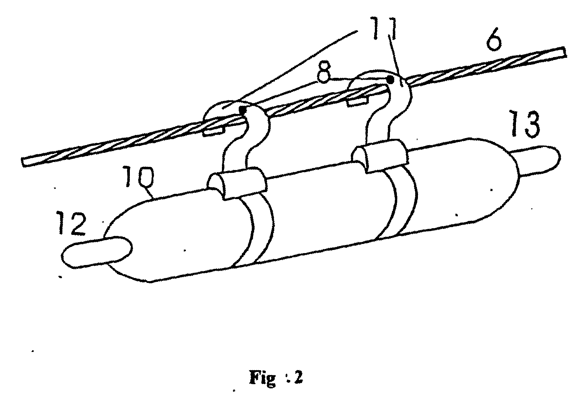

In Fig. 2 sind ein Gehäuse 10 der Vorrichtung, Mittel 11 zur Befestigung des Gehäuses 10 am Draht 6, Antennen 12, 13 der Einheit 5 und des Empfängers 9, der Draht 6 und der Sensor 8 gezeigt, die in das Mittel 11 eingebaut sind (der Sensor 7 ist in Fig. 2 nicht gezeigt, und der Sensor 8 besteht aus zwei Teilen).

Die Einheit 4 ist mit dem Ausgang der Einheit 3 und dem Eingang der Einheit 5 verbunden und erfüllt die Funktionen der vorläufigen Bearbeitung der ermittelten Informationen und der nachfolgenden Datenspeicherung. Die Einheit 5 gewährleistet die Verbindung und die Übertragung der Daten an die Erfassungsstelle der Messinformationen. Die Einheiten 2, 4 und 5 können auf der Basis der Mikroprozessortechnik mit einer Softwaresteuerung ausgeführt werden und konstruktiv mit der Einheit 3 zu einer einheitlichen Mess- und Übertragungseinheit 14 vereinigt werden.

Ein Mittel 15 zur Kopplung mit dem öffentlichen Zellenfunknetz, mit dem das Modul 14 ausgerüstet ist, ist in Fig. 1 als Bestandteil der Einheit 5 gezeigt. Die Einheit 5 kann auch mit Mitteln zum Empfang von Signalen, zum Abfragen der Informationen, der digitalen Sollwerte sowie mit Mitteln zum Schutz vor unbefugtem Zugriff ausgerüstet werden, die in Fig.1 nicht gezeigt sind.

Der Sensor 7 arbeitet als Stromtransformator und kann konstruktiv beispielsweise nach Art einer Stromzange ausgeführt werden. Der Sensor 8 kann auf der Basis von einem oder zwei Thermopaaren ausgeführt werden, die nach Fig. 2 in die Mittel 11 zur Befestigung des Gehäuses 10 am Draht 6 eingebaut sind. Der Empfänger 9, mit dem das Modul 14 ausgerüstet ist, ist in Fig.1 als Bestandteil der Einheit 3 gezeigt. Der Empfänger 9 kann auf der Basis einer serienmäßig hergestellten Mikroschaltung eines GPS- Empfängers ausgeführt sein. Die Antennen 12 und 13 sind jeweils an der Einheit 5 und dem Empfänger 9 angeschlossen und gewährleisten deren Funktionieren.

Die Vorrichtung wird unmittelbar am Draht der Hochspannungsfernleitung in einer der Stützweiten der Fernleitung, vorzugsweise in der Mitte der Stützweite oder an der Stelle des maximalen Durchhangs des Drahts, angebracht und funktioniert folgendermaßen.

Mittels des Sensors 8 empfängt die Einheit 3 ein analoges, elektrisches Signal, das der Temperatur des Drahts 6 entspricht, wandelt es in digitale Daten um und übermittelt diese an die Einheit 4, in der sie gespeichert, gesammelt und vorläufig bearbeitet werden. Mittels des Sensors 7 empfängt die Einheit 3 das analoge, elektrische Signal, das dem Strom in der Leitung entspricht (und der Information über Stromwert, Frequenz, Phase usw.), wandelt es in digitale Daten um und übertragt diese in die Einheit 4, in der sie gespeichert, gesammelt und vorläufig bearbeitet werden.

Mittels des Empfängers 9 empfängt die Einheit 3 die Signale von den Satelliten des globalen Positionierungssystems GPS, wie in [7] beschrieben ist. Der Empfänger 9 ist mit einem Analysator der Signale des GPS-Systems versehen, der periodisch (ungefähr einmal pro Mikrosekunde) die Position des Empfängers im dreidimensionalen Koordinatensystem ermittelt. Die Daten über die Koordinaten des Empfängers 9 (d.h. des Drahts 6) gelangen von der Einheit 3 in die Einheit 4, in der sie ebenso wie die Daten über die anderen Parameter gespeichert, gesammelt und vorläufig bearbeitet werden. Dabei wird eine gewisse Erhöhung des Auslösungsvermögens des Empfängers gewährleistet, die die verhältnismäßig geringen Verschiebungen des Drahts der Hochspannungsfernleitung mittels des GPS-Systems zu messen erlaubt, das ursprünglich für die Ermittlung der Position von mobilen Objekten vorbestimmt war. Ein solcher Effekt hängt damit zusammen, dass vor der Entstehung von intensiven Schwingungen der Leitung der Empfänger der GPS-Signale diese Signale eine längere Zeit empfängt, wobei er sich praktisch im stationären Zustand befindet.

Von der Einheit 4 gelangen die Daten in die Einheit 5, die die Datenübertragung zur Erfassungsstelle gewährleistet (dort werden die Daten über den Zustand des Drahts, wie Temperatur, Strom und Raumposition, erfaßt).

Wenn bei der Verwirklichung der Erfindung das Modul 14 mit dem Mittel 15 (Modem) ausgerüstet ist, erfolgt die Datenübertragung über das öffentliche Zellenfunknetz. Die Datenübertragung kann periodisch in Abständen, z. B. von 15 Minuten, oder aufgrund einer Abfrage von der Datenerfassungsstelle und einer Bearbeitung erfolgen. Im letzten Fall soll die Einheit 5 mit Mitteln ausgerüstet werden, die den Empfang der Abfragesignale gestatten, und die Einheit 5 kann mit der Einheit 2 über eine Vielfachleitung 16 verbunden sein, die die Arbeit der Vorrichtung auslöst.

In der Datenerfassungs- und Bearbeitungsstelle erfolgt der Empfang der Daten und die Übertragung der Steuersignale (Anfragen in Bezug auf die Übertragung und Einstelldaten) z. B. mit einem PC, dessen Kopplung mit dem Kommunikationskanal über die öffentliche Telefonleitung mit Hilfe eines üblichen Modems realisiert werden kann.

Die vorgeschlagene Vorrichtung verwendet die bekannten, öffentlichen Kommunikationsmittel (Signale des GPS-Systems und das Zellenfunknetz), um die spezifische Aufgabe der Überwachung der Parameter über den Zustand des Drahts der Hochspannungsfernleitung zu lösen. Dabei wird der Zellenfunk nicht nach seiner direkten Zweckbestimmung (Fernsprechverkehr von mobilen Teilnehmern), sondern für die Sicherung der technologischen, telefonischen Verbindung mit dem Objekt verwendet, der unter hoher Spannung steht. Das technische Ergebnis des Einsatzes des Zellenfunks bei der Erfindung besteht darin, dass die Notwendigkeit ausgeschlossen wird, sowohl die Mittel der Hochspannungsentkopplung als auch das spezialisierte, technologische Kommunikationssystem zu schaffen und zu betreiben. Dabei wird die Zuverlässigkeit des unabhängigen Betriebs der Vorrichtung erhöht, d.h. das Funktionieren des öffentlichen Telefonnetzes (einschließlich des Zellenfunks) bleibt in der Regel bei Ausfällen und Störungen der einzelnen Leitungen, der Hochspannungsunterstationen, Kraftwerke und sogar der Energiesysteme erhalten.

Wichtig ist, dass der übliche, beispielsweise aus [8] bekannte Einsatz der mobilen Telefonkommunikation im System der Fernüberwachung von Haushaltsgeräten die Datenübertragung unmittelbar von den Elementen (Sensoren) nicht vorsieht, die auf den stromleitenden und sogar auf den Hochspannungsteilen der Ausrüstung angebracht sind, und folglich ist bei einem solchen Einsatz das oben genannte, technische Ergebnis nicht zu verzeichnen. In [8] wird eine andere Aufgabe gelöst, und es wird ein anderes technisches Ergebnis erreicht (die Möglichkeit der Verwendung eines fertigen und schon beim Benutzer vorhandenen Mittels, nämlich das mobile Telefon als abgesetztes Terminal des Systems), das auf einer solchen Eigenschaft der mobilen Telefone basiert, wie das Vorhandensein eines Displays für die Abbildung von Anweisungen und von Ergebnissen der Überwachung von Haushaltsgeräten.

Das erfinderische Niveau dieses Vorschlags wird zum Beispiel dadurch bestätigt, dass in der Quelle [9], die ein Überwachungssystem der Parameter von elektroenergetischen Objekten in schwer zugänglichen Orten (auf den Hochspannungs- und sich drehenden Teilen der elektrischen Ausrüstung) beschreibt, die Verwendung des Zellenfunks für dieses Ziel nicht in Betracht gezogen wird; die Verwendung der Signale des GPS-Systems ist durch die Aufgabe der Gewinnung eines Merkzeichens der Zeit und der Synchronisationen der Messungen beschränkt.

Die Anwendbarkeit der Erfindung verlangt die Erfüllung mindestens einer von zwei Anforderungen an den Ort der Unterbringung der Vorrichtung auf der Hochspannungsfernleitung, und zwar
- muss sich die Vorrichtung im Zugangsbereich von mindestens einem mobilen Telefonnetz befinden,
- muss die Vorrichtung für das gleichzeitige Empfangen der Signale von mindestens drei Satelliten der GPS-Gruppierung zugänglich sein.

Zur Zeit wird die erste Anforderung hauptsächlich in entwickelten, dicht besiedelten Gebieten erfüllt, während die zweite Anforderung (dank der großen Gesamtanzahl der Orbitalobjekte der GPS-Gruppierung, die sich gleichmäßig auf der Umlaufbahn um die Erde befinden) praktisch an jedem beliebigen Punkt der Erdoberfläche erfüllt ist.

Die Erfüllung der ersten Anforderung ermöglicht, die Erfindung in der ersten Variante ihrer Realisierung zu verwenden, die Erfüllung der zweiten Anforderung gelingt durch die zweite Variante. In den beiden Fällen wird das technische Ergebnis der Erfindung, und zwar die Erhöhung der Zuverlässigkeit des unabhängigen Betriebs der Vorrichtung, gewährleistet.

Andererseits kann die Wahl der Variante der Realisierungen der Erfindung durch wirtschaftliche Überlegungen und die vorrangige Aufgabe der Überwachung des Zustands des Drahts der Hochspannungsfernleitung bestimmt sein, die beispielsweise vom Vorhandensein von eisgefährdeten Bereichen, von der Stärke und der Richtung der herrschenden Winde an der Hochspannungsfernleitung entlang sowie von der Belastung der Leitung abhängen.

Auf diese Weise kann in Abhängigkeit von konkreten Bedingungen des Durchgangs der Hochspannungsfernleitung die Vorrichtung gemäß der Erfindung in zwei Grundvarianten realisiert werden. Jede dieser Varianten sieht die Möglichkeit jeweils weiterer Ausbildungen der Erfindung mit der weiteren Erhöhung der Zuverlässigkeit und der Autonomie des Betriebs vor, wenn an der Stelle der Unterbringung der Vorrichtung die beiden oben genannten Anforderungen erfüllt werden.

### Quellenangabe des Stands der Technik

[1] Mobiles unabhängiges Thermoregister PTB-1, WWW.carat-ndt.ru/rtv2.htm
[2] Laser range finder LEM 300-GEO, www.ienoptik-los.de/lasersensor/range finder /lem 300gea.html.
[3] M. Corti, S. Marazzini, F.Tavano. Misura a distanza delle vibrazioni dei conduttori delle linee elettriche aeree mediante l'impiego di laser, 85a Riunione Annuele dell'AEl, ottobre 1984.
[4] T. Seppa et al., Use of on-line tension monitoring for real-time thermal rating, ice loads, and other environmental effects, CIGRE Session 1998, report 22-102.
[5] RF-Patent Nr. RU 2143165, MPK H02J 13/00, G01R 15/06,1999, Vorrichtung zur Überwachung von Strom -und Energiesystemen.
[6] Mikutskij G.V., Vorrichtung für die Bearbeitung und den Anschluss von Hochfrequenzkanälen. Moskau, Verlag Energija, 1974, S. 106-158.
[7] Understanding GPS: principles and applications, Edition Elliot D. Kaplan, Arteeh Hons. Boston, London, 1996.
[8] PCT-Anmeldung Nr. WO 01/28068, H02J,13/00, 2001, System for monitoring and controlling a set of household appliances.
[9] PCT-Anmeldung Nr. WO 01/17092, MPK H02J,13/00, 2001, Electric power supervision.

### Bezugszeichenliste

- 1: Stromversorgungseinheit,
- 2: Steuereinheit,
- 3: Einheit zum Empfangen und Umwandeln der Signale über den Zustand der Leitung der Hochspannungsfernleitung,
- 4: Einheit zur vorläufigen Datenbearbeitung und zur nachfolgenden Datenspeicherung,
- 5: Einheit zur Kommunikation und Datenübertragung,
- 6: Draht der Hochspannungsfernleitung,
- 7: Sensor für die Stromparameter im Draht 6,
- 8: Messfühler für die Drahttemperatur,
- 9: Signalempfänger für das globale Positionierungssystem GPS mit der Ermittlung seiner Position Lage im dreidimensionalen Koordinatensystem (GPS-Empfänger),
- 10: Gehäuse der Vorrichtung,
- 11: Mittel zur Befestigung des Gehäuses 10 am Draht 6,
- 12: Antenne der Einheit 5,
- 13: Antenne des Empfängers 9,
- 14: Mess- und Übertragungseinheit,
- 15: Mittel zur Kopplung mit dem öffentlichen Zellenfunknetz,
- 16: Vielfachleitung

## Patentansprüche

1. Vorrichtung zur Fernüberwachung einer elektrischen Fernleitung mit einem Gehäuse (10), das mit Mitteln (11) zur Befestigung an einem Draht (6) der Fernleitung ausgerüstet ist, mit einer im Gehäuse untergebrachten Stromversorgungseinheit (1) und mit einer Mess- und Übertragungseinheit (14),
**dadurch gekennzeichnet,**
**dass** die Mess- und Übertragungseinheit (14) Signale des globalen Positionierungssystems (GPS) empfangen, nach diesen Signalen die Position der Vorrichtung im dreidimensionalen Koordinatensystem ermitteln und die ermittelten Daten über die Koordinaten an eine Erfassungsstelle der Messinformationen übermitteln kann.

2. Vorrichtung nach Anspruch 1,
**dadurch gekennzeichnet,**
**dass** die Mess- und Übertragungseinheit (14) eine Steuereinheit (2), eine Einheit (3) zum Empfangen und Umwandeln der Signale über den Zustand der elektrischen Fernleitung mit einem GPS-Signalempfänger, eine Einheit (4) zur vorläufigen Datenbearbeitung und zur nachfolgenden Datenspeicherung, sowie eine Einheit (5) zur Kommunikation und Datenübertragung umfasst, wobei die Einheit (4) zur vorläufigen Datenbearbeitung und zur nachfolgenden Datenspeicherung am Ausgang der Einheit (3) zum Empfangen und Umwandeln der Signale über den Zustand der elektrischen Fernleitung mit einem GPS-Signalempfänger sowie am Eingang der Einheit (5) zur Kommunikation und Datenübertragung angeschlossen ist.

3. Vorrichtung nach Anspruch 1,
**dadurch gekennzeichnet,**
**dass** die Mess- und Übertragungseinheit (14) an einen Dienstkanal des öffentlichen Zellenfunknetzes angepasst ist (mittels 15, 12).

4. Vorrichtung nach Anspruch 2,
**dadurch gekennzeichnet,**
**dass** die Einheit (3) zum Empfangen und Umwandeln der Signale über den Zustand der elektrischen Fernleitung einen Sensor (7) zur Ermittlung der Stromparameter im Draht (6) aufweist.

5. Vorrichtung nach Anspruch 2,
**dadurch gekennzeichnet,**
**dass** die Einheit (3) zum Empfangen und Umwandeln der Signale über den Zustand der elektrischen Fernleitung einen Sensor (8) zur Ermittlung der Temperatur im Draht (6) aufweist.

6. Vorrichtung nach Anspruch 5,
**dadurch gekennzeichnet,**
**dass** der Sensor (8) zur Ermittlung der Temperatur im Draht (6) im Mittel (11) zur Befestigung des Gehäuses (10) am Draht (6) der elektrischen Fernleitung angeordnet ist.

7. Vorrichtung nach Anspruch 2,
**dadurch gekennzeichnet,**
**dass** die Einheit (5) zur Kommunikation und Datenübertragung mit Mitteln zum Empfang der Abfragesignale, zum Einstellen digitaler Daten und zum Schutz vor unbefugtem Zugriff ausgerüstet ist.

8. Vorrichtung nach Anspruch 1,
**dadurch gekennzeichnet,**
**dass** die Stromversorgungseinheit (1) als Akkumulator ausgebildet ist.

9. Vorrichtung nach Anspruch 8,
**dadurch gekennzeichnet,**
**dass** der Akkumulator (1) mit Mitteln zum Nachladen durch den Strom der Fernleitung ausgerüstet ist.

10. Vorrichtung nach Anspruch 8,
**dadurch gekennzeichnet,**
**dass** der Akkumulator (1) mit Mitteln zum Nachladen durch eine zusätzlich vorgesehene, auch als Sonnenbatterie bezeichnete Solarzelle ausgerüstet ist.

## Claims

1. Apparatus for remotely monitoring an overhead power line, the said apparatus including a housing (10), which is provided with means (11) for securement to a wire (6) of the overhead power line, a power supply unit (1) that is accommodated in the housing and a measuring and transmitting unit (14), **characterised in that** the measuring and transmitting unit (14) can receive signals of the global positioning system (GPS), determine the position of the apparatus in the three-dimensional system of co-ordinates according to the said signals and transmit the data determined by means of the co-ordinates to a measuring data acquisition unit.

2. Apparatus according to claim 1, **characterised in that** the measuring and transmitting unit (14) includes a control unit (2), a unit (3) for receiving and converting the signals concerning the state of the overhead power line with a GPS signal receiver, a unit (4) for temporary data processing and for subsequent data storage, as well as a unit (5) for communication and data transmission, wherein the unit (4) for temporary processing and for subsequent data storage is connected at the output of the unit (3) for receiving and converting the signals concerning the state of the overhead power line with a GPS signal receiver as well as at the input of the unit (5) for communication and data transmission.

3. Apparatus according to claim 1, **characterised in that** the measuring and transmitting unit (14) is adapted to a service channel of the public cell radio network (by means of 15, 12).

4. Apparatus according to claim 2, **characterised in that** the unit (3) for receiving and converting the signals concerning the state of the overhead power line includes a sensor (7) for determining the current parameters in the wire (6).

5. Apparatus according to claim 2, **characterised in that** the unit (3) for receiving and converting the signals concerning the state of the overhead power line includes a sensor (8) for determining the temperature in the wire (6).

6. Apparatus according to claim 5, **characterised in that** the sensor (8) for determining the temperature in the wire (6) is disposed in the means (11) for securing the housing (10) on the wire (6) of the overhead power line.

7. Apparatus according to claim 2, **characterised in that** the unit (5) for communication and data transmission is provided with means for receiving the interrogation signals, for adjusting digital data and for protection against unauthorised access.

8. Apparatus according to claim 1, **characterised in that** the power supply unit (1) is in the form of an accumulator.

9. Apparatus according to claim 8, **characterised in that** the accumulator (1) is provided with means for recharging using the current of the overhead power line.

10. Apparatus according to claim 8, **characterised in that** the accumulator (1) is provided with means for recharging using an additionally provided solar cell that is also identified as a solar battery.

## Revendications

1. Dispositif de contrôle à distance d'une ligne aérienne électrique comprenant un boîtier (10) qui est équipé de moyens (11) de fixation à un fil (6) de la ligne aérienne, une unité (1) d'alimentation en courant logée dans le boîtier et une unité (14) de mesure et de transmission,
**caractérisé**
**en ce que** l'unité (14) de mesure et de transmission peut recevoir des signaux du système global de positionnement (GPS), déterminer par ces signaux la position du dispositif dans le système de coordonnées en trois dimensions et transmettre les données transmises par les coordonnées à un point de relevé des informations de mesure.

2. Dispositif suivant la revendication 1,
**caractérisé**
**en ce que** l'unité (14) de mesure et de transmission comprend une unité (2) de commande, une unité (3) de réception et de transformation des signaux sur l'état de la ligne aérienne électrique ayant un récepteur de signal GPS, une unité (4) de traitement temporaire de données et de mémorisation ultérieure de données, ainsi qu'une unité (5) de communication et de transmission de données, l'unité (4) de traitement temporaire de données et de mémorisation ultérieure de données étant raccordée à la sortie de l'unité (3) de réception et de transformation des signaux sur l'état de la ligne aérienne électrique comprenant un récepteur de signal GPS, ainsi qu'à l'entrée de l'unité (5) de communication et de transmission des données.

3. Dispositif suivant la revendication 1,
**caractérisé**
**en ce que** l'unité (14) de mesure et de transmission est adaptée à un canal de service du réseau radio cellulaire public (moyens 15, 12).

4. Dispositif suivant la revendication 2,
**caractérisé**
**en ce que** l'unité (3) de réception et de transformation des signaux sur l'état de la ligne aérienne électrique comporte un capteur (7) de détermination des paramètres du courant dans le fil (6).

5. Dispositif suivant la revendication 2,
**caractérisé**
**en ce que** l'unité (3) de réception et de transformation des signaux sur l'état de la ligne aérienne électrique comporte un capteur (8) de détermination de la température du fil (6).

6. Dispositif suivant la revendication 5,
**caractérisé**
**en ce que** le capteur (8) de détermination de la température du fil (6) est disposé dans le moyen (11) de fixation du boîtier (10) au fil (6) de la ligne aérienne électrique.

7. Dispositif suivant la revendication 2,
**caractérisé**
**en ce que** l'unité (5) de communication et de transmission de données est équipée de moyens de réception des signaux d'interrogation pour le réglage des données numériques et pour la protection vis-à-vis d'un accès qui n'est pas autorisé.

8. Dispositif suivant la revendication 1,
**caractérisé**
**en ce que** l'unité (1) d'alimentation en courant est constituée sous la forme d'un accumulateur.

9. Dispositif suivant la revendication 8,
**caractérisé**
**en ce que** l'accumulateur (1) est équipé de moyens de recharge par le courant de la ligne aérienne.

10. Dispositif suivant la revendication 8,
**caractérisé**
**en ce que** l'accumulateur (1) est équipé de moyens de recharge par une pile solaire prévue supplémentairement, désignée également par batterie solaire.
